# EUROPÄISCHE PATENTSCHRIFT

(11) **EP 1 908 123 B1**
(45) Veröffentlichungstag und Bekanntmachung des Hinweises auf die Patenterteilung: **19.08.2015**
(21) Anmeldenummer: 06775724.5
(22) Anmeldetag: 20.07.2006
(51) Int. Cl.: H01L 33/20, H01L 33/58

(54) **LICHTEMITTIERENDE HALBLEITERDIODE HOHER LICHTLEISTUNG**
LIGHT-EMITTING SEMICONDUCTOR DIODE HAVING HIGH LIGHT-EXTRACTION EFFICIENCY
DIODE ELECTROLUMINESCENTE A SEMI-CONDUCTEUR AYANT UN HAUT RENDEMENT LUMINEUX

(30) Priorität: 21.07.2005 DE 102005034793
(43) Veröffentlichungstag der Anmeldung: 09.04.2008
(73) Patentinhaber: Merck Patent GmbH, 64293 Darmstadt (DE)
(72) Erfinder: OPPERMANN, Hermann, 10435 Berlin (DE); MUSCHAWECK, Julius, 82131 Gauting (DE); KUNZE, Jochen, 47441 Moers (DE); LUCE, Thomas, 73730 Esslingen (DE); KROCHMANN, Eike, 72654 Neckartenzlingen (DE); TEWS, Walter, 17489 Greifswald (DE); ROTH, Gundula, 17498 Leverhagen (DE)
(74) Vertreter: Horstmann, Stefan
(86) Internationale Anmeldenummer: PCT/DE2006/001267
(87) Internationale Veröffentlichungsnummer: WO 2007/009449

(56) Entgegenhaltungen:
- DE-A1- 19 638 667
- DE-A1- 19 918 370
- US-A1- 2004 069 993
- US-A1- 2004 217 369

## Beschreibung

Die Erfindung betrifft eine lichtemittierende Halbleiterdiode, die mindestens einen lichtemittierenden Chip und einen diesen zumindest bereichsweise umgebenden transparenten Elektronikschutzkörper umfasst sowie ein Verfahren zu ihrer Herstellung.

Aus der DE 196 38 667 C2 ist eine derartige lichtemittierende Halbleiterdiode bekannt. Auf dem Elektronikschutzkörper liegt eine Lichtkonversionsschicht auf, die eine linsenförmige Abdeckung trägt. Um einen homogenen Farbeindruck im Raum zu erreichen, wird das Licht in der Konversionsschicht gestreut. Eine Wärmeableitung ist nicht vorgesehen. Diese Halbleiterdiode ist daher nur für geringe Lichtleistungen einsetzbar.

Der vorliegenden Erfindung liegt daher die Problemstellung zugrunde, eine lichtemittierende Halbleiterdiode mit hoher Lichtleistung und ein Verfahren zu ihrer Herstellung zu entwickeln.

Diese Problemstellung wird mit den Merkmalen des Hauptanspruches gelöst. Zumindest auf dem Elektronikschutzkörper ist mindestens bereichsweise eine Schichtverbundfolie aufgebracht. Die Schichtverbundfolie weist eine dem Elektronikschutzkörper abgewandte Trägerschicht auf, deren Brechungsindex größer ist als der Brechungsindex des Elektronikschutzkörpers. Außerdem umfasst die Schichtverbundfolie eine dem Elektronikschutzkörper zugewandte Schicht, deren Grundwerkstoff der Werkstoff des Elektronikschutzkörpers ist.

Zur Herstellung dieser lichtemittierenden Halbleiterdiode wird ein lichtemittierender Chip mit einem unter Hitzeeinwirkung aushärtenden transparenten Kunststoff zur Erzeugung eines Elektronikschutzkörpers umgossen. Eine Schicht konstanter Stärke von maximal 200 Mikrometer, deren Grundwerkstoff gleich dem Werkstoff des Elektronikschutzkörpers ist, wird zur Herstellung einer Schichtverbundfolie auf eine Trägerfolie, die einen höheren Brechungsindex als der Elektronikschutzkörper hat, aufgebracht. Die so hergestellte Schichtverbundfolie wird auf den Elektronikschutzkörper aufgebracht und die Schicht mit dem Elektronikschutzkörper unter Hitzeinwirkung oder UV-Strahlungseinwirkung verbunden.

Weitere Einzelheiten der Erfindung ergeben sich aus den Unteransprüchen und der nachfolgenden Beschreibung einer schematisch dargestellten Ausführungsform.

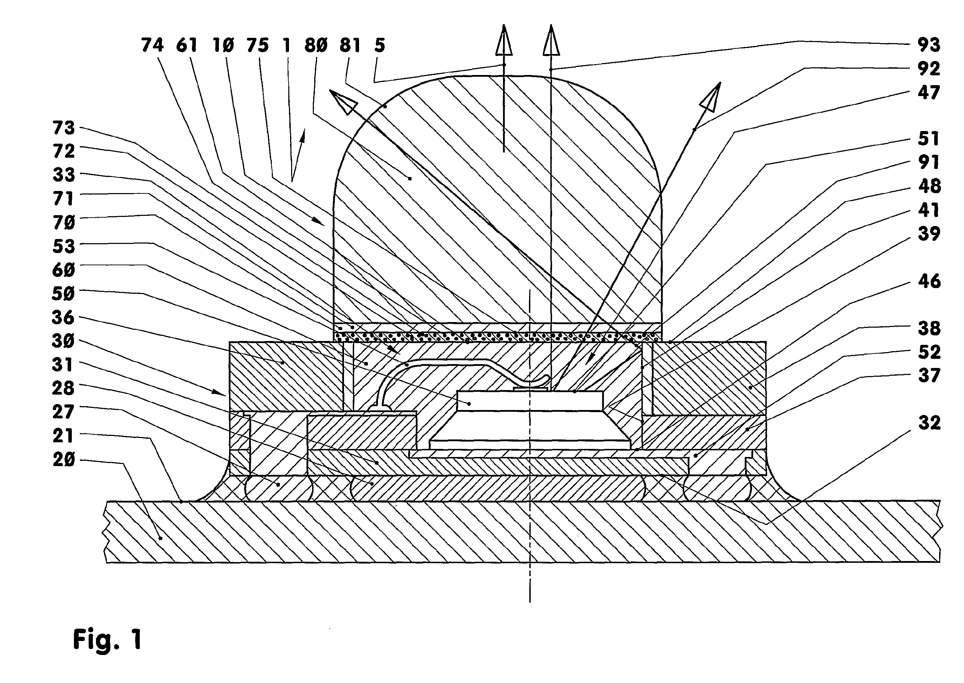

### Figur 1: Schnitt durch eine lichtemittierende Halbleiterdiode.

Die Figur 1 zeigt einen Schnitt durch eine lichtemittierende Halbleiterdiode (10). Auf einer Platine (20), z.B. einer Metallkernplatine (20), sitzt ein beispielsweise topfartiges Gehäuse (30), auf dessen Boden (31) z.B. ein lichtemittierender Chip (50) befestigt ist. Der lichtemittierende Chip (50) ist von einem Elektronikschutzkörper (60) umgeben. Auf dem Elektronikschutzkörper (60) ist eine Schichtverbundfolie (70) angeordnet, die den Elektronikschutzkörper (60) von einem diesem optisch nachgeschalteten Lichtverteilkörper (80) trennt.

Der lichtemittierende Chip (50) ist beispielsweise ein lichtstarker, großer LED-Chip mit z.B. quadratischer Grundfläche. Seine Kantenlänge beträgt aufgrund der hohen Leistung beispielsweise zwischen 750 Mikrometern und 1250 Mikrometern. Die Kanten des lichtemittierenden Chips (50) können auch größer oder kleiner als diese Längen sein. Der lichtemittierende Chip (50) emittiert beispielsweise im blauen oder im ultravioletten Bereich. Er kann aber auch Licht einer anderen Farbe emittieren. Anstatt eines einzelnen lichtemittierenden Chips (50) kann die lichtemittierende Halbleiterdiode (10) auch mehrere Chips (50), z.B. unterschiedlicher Wellenlänge, umfassen.

Das Gehäuse (30), z.B. ein Submount (30), umfasst den Boden (31) und hierauf stehende Seitenwände (36). In diesem Ausführungsbeispiel bestehen die Seitenwände (36) aus einem unteren Abschnitt (37) und einem oberen Abschnitt (38), die beispielsweise miteinander und mit dem Boden (31) verklebt sind. Das Gehäuse (30) kann aber auch einteilig ausgeführt sein. Die Höhe der Seitenwände (36) beträgt zwischen 200 Mikrometer und 950 Mikrometern. Die Grundfläche (32) des Gehäuses (30), mit der das Gehäuse (30) auf der Metallkernplatine (20) aufsitzt, kann z.B. rund, eckig, quadratisch etc. sein. Diese Fläche (32) ist größer oder gleich der Bodenfläche des Kegelstumpfes eines Kegels mit rechtwinkliger Spitze, dessen Deckfläche der lichtemittierende Chip (50) ist.

Die Innenwandungen (39) der Seitenwände (36) stehen beispielsweise senkrecht zum Boden (31). Sie können aber auch mit dem Boden (31) einen Winkel einschließen, der größer oder geringfügig kleiner ist als 90 Grad. So kann beispielsweise die Öffnung (33) des Gehäuses (30) zumindest annähernd die gleiche Größe haben wie der lichtemittierende Chip (50).

Das Gehäuse (30) hat als Grundwerkstoff einen nichtmetallischen wärmeleitenden Werkstoff, z.B. einem keramischen Werkstoff. Dies kann beispielsweise AlN, BeO, Al₂O₃ etc. sein. Das Gehäuse (30) kann Schichten oder Bereiche umfassen, die aus anderen Werkstoffen hergestellt sind.

Die Innenwandungen (39) sind in diesem Ausführungsbeispiel mit einer reflektierenden Schicht (41) metallisiert. Diese reflektierende Schicht (41) kann so ausgebildet sein, dass das vom Chip (50) emittierte Licht zumindest annähernd in Richtung der Hauptlichtabstrahlrichtung (5) - also in eine Richtung normal zur Oberfläche (51) des lichtemittierenden Chips (50) - reflektiert wird. Auch eine andere Ausführung der Verspiegelung ist denkbar.

Auf dem Innenboden (46) des Gehäuses (30) ist der lichtemittierende Halbleiterchip (50) angeordnet. Der Chip (50) ist hier mittels einer thermisch und elektrisch leitenden Verbindung (52) sowie mittels eines Bonddrahtes (53) mit dem Gehäuse (30) verbunden.

Die thermisch leitenden und die elektrisch leitenden Verbindungen können voneinander getrennt sein. So kann die thermisch leitfähige Verbindung eine Lötverbindung, eine Klebeverbindung, eine Thermokompressionsverbindung etc. sein. Diese Verbindungen können mit oder ohne Zusatzstoffe mit hoher Wärmeleitfähigkeit ausgeführt sein. Bei einem derartigen Aufbau wird die elektrische Verbindung beispielsweise mittels zweier Bonddrähte hergestellt. Diese sind dann beispielsweise mit metallbeschichteten Flächen des Gehäuses (30) verbunden.

Auch eine Ausführung ohne Bonddrähte, z.B. in Flip-Chip-technologie, ist denkbar. Hierbei sind beispielsweise beide Kontakte des lichtemittierenden Chips (50) direkt mit dem Gehäuse (30) verbunden.

In der in der Figur 1 dargestellten lichtemittierenden Halbleiterdiode (10) hat der lichtemittierende Halbleiterchip (50) beispielsweise eine Kantenlänge von 900 Mikrometern. Die Fläche des Innenbodens (46) hat in diesem Ausführungsbeispiel einen quadratischen Querschnitt mit einer Kantenlänge von einem Millimeter. Die Seitenwände (36) sind hier 550 Mikrometer hoch, wobei die Seitenwände (36) den lichtemittierenden Chip (50) um 300 Mikrometer überragen.

Der Elektronikschutzkörper (60) füllt den Innenraum (47) des Gehäuses (30) aus. Er umgibt den lichtemittierenden Chip (50). Seine normal zur Hauptlichtausbreitungsrichtung (5) liegende Stirnfläche (61) ist beispielsweise bündig mit der Stirnfläche (48) des Gehäuses (30). Der Elektronikschutzkörper (60) ist ein homogener Körper aus einem transparenten Kunststoff. Dies ist z.B. ein UV-härtender Kunststoff, ein Silikon, etc. Sein Brechungsindex liegt beispielsweise zwischen 1,4 und 1,45, er kann aber auch bei einem Wert bis 2,5 liegen. Der Werkstoff des Elektronikschutzkörpers (60) ist z.B. niedrigviskos und additiv vernetzend. Beim Aushärten ergibt sich so eine plane Stirnfläche (61) des Elektronikschutzkörpers (60), wobei der Elektronikschutzkörper (60) beim Aushärten nur einer geringen Schrumpfung unterworfen ist.

Die Schichtverbundfolie (70) besteht in diesem Ausführungsbeispiel aus einer Trägerschicht (71) und einer Konverterschicht (72). Hierbei ist die Konverterschicht (72) mit dem Elektronikschutzkörper (60) verbunden und liegt beispielsweise auf der Stirnfläche (48) des Gehäuses (30) auf. Die Schichtverbundfolie (70) hat hier eine konstante Stärke.

Die Trägerschicht (71) ist eine optisch transparente Kunststofffolie, z.B. aus Thermoplast, beispielsweise ein Polycarbonat, Polysulfon, PMMI oder ein anderer Thermoplast. Sie hat einen Brechungsindex, der höher ist als der Brechungsindex des Elektronikschutzkörpers (60). Hat beispielsweise der Elektronikschutzkörper (60) einen Brechungsindex von 1,45, weist die Trägerschicht (71) z.B. einen Brechungsindex zwischen 1,5 und 1,7 auf. Der Brechungsindex der Trägerschicht (71) kann aber auch höher liegen. Bei einem Elektronikschutzkörper (60) mit einem Brechungsindex von 2,5 hat die Trägerschicht (71) dann beispielsweise einen Brechungsindex von 3,0. Die Stärke der Trägerschicht (71) beträgt zwischen 50 Mikrometern und einem Millimeter. Im hier dargestellten Ausführungsbeispiel hat die Trägerschicht (71) eine Stärke von 150 Mikrometern.

Die Konverterschicht (72) besteht aus einem Grundwerkstoff (73) und darin eingebettetem Konvertermaterial (74). Der Grundwerkstoff (73) ist der Werkstoff, aus dem der Elektronikschutzkörper (60) hergestellt ist. Das Konvertermaterial (74) ist beispielsweise ein Pulver, z.B. ein Phosphorpulver. Die Stärke der Konverterschicht (72) beträgt zwischen 35 und 200 Mikrometern.

Das Konvertermaterial (74) ist ein Phosphor oder ein Gemisch aus Phosphoren, die im ultravioletten und/oder sichtbaren Spektralbereich absorbieren und Licht aussenden, das langwelliger ist als die primäre Strahlung des lichtemittierenden Chips (50). Dabei wird das Konvertermaterial (74) z.B. aus einem oder mehreren Phosphoren aus der Gruppe der sauerstoffhaltigen Phosphore gebildet, wobei oxidische Verbindungen und/oder solche Phosphore eingesetzt sind, die als dominierendes Zentralion vorzugsweise Si, Al, P oder Ge enthalten.

Die auf die Trägerschicht (71) aufgebrachte Schicht (72) kann zusätzlich mit weiteren Materialien, z.B. mit Partikeln für die Streuung der transmittierten Strahlung, gefüllt sein. Diese Schicht (72) kann auch ohne Konverterpartikel (74) ausgeführt sein. Auch kann die Schichtverbundfolie (70) weitere Schichten umfassen, die zwischen der Konverterschicht (72) und der Trägerschicht (71) angeordnet sind. Diese Schichten haben dann beispielsweise jeweils einen Brechungsindex, der höher ist als der Brechungsindex des Elektronikschutzkörpers (60).

Der Lichtverteilkörper (80) ist in diesem Ausführungsbeispiel ein transparenter Körper, der z.B. eine optische Linse (81) umfasst. Er sitzt auf der Trägerschicht (71) und ist mit dieser z.B. verschmolzen. Der Lichtverteilkörper (80) ist aus dem Werkstoff der Trägerschicht (71) hergestellt.

Die lichtemittierende Halbleiterdiode (10) kann beispielsweise ohne einen Lichtverteilkörper (80) ausgeführt sein. Auch eine Ausführung ohne Gehäuse (30) und/oder ohne Platine (20) ist denkbar.

Zur Herstellung der lichtemittierenden Halbleiterdiode (10) wird beispielsweise zunächst der lichtemittierende Halbleiterchip (50) in das Gehäuse (30) eingesetzt. Hierbei wird der lichtemittierende Chip (50) mittels Kleben, Bonden, Löten, Thermokompressionsschweißen etc. mit dem Gehäuse (30) verbunden. Die beim Löten eingesetzten Lote können z.B. aus SnAg, AuSn, AuGe, etc. sein. Beim Bonden werden beispielsweise leicht verformbare Werkstoffe wie Au, Ag, Cu, Al, In, etc. verwendet. Für das Kleben kommen z.B. elektrisch und thermisch leitfähige Klebstoffe, beispielsweise ein mit Silberpartikeln gefülltes Epoxyd, zum Einsatz.

Das Gehäuse (30) mit dem lichtemittierenden Chip (50) wird dann auf die Metallkern-Platine (20) gelötet oder geklebt. In dem hier dargestellten Ausführungsbeispiel sind das Gehäuse (30) und die Platine (20) mittels flächenhafter Lotdepots (27) mit großer Wärmeabfuhrfläche verbunden. Beim Löten können auch Lötkugeln aus einem Weichlot mit Selbstzentrierung, Lötkugeln mit einem nichtschmelzenden Kern, etc. eingesetzt werden. Hierdurch wird eine gute thermische Verbindung zwischen beiden Bauteilen (20, 30) erzeugt. In der in der Figur 1 dargestellten lichtemittierenden Halbleiterdiode (10) ist zwischen dem Gehäuse (30) und der Platine (20) ein wärmeleitendes Polymer (28), ein sogenannter Underfiller, eingebracht. Dies kann z.B. ein gefülltes Epoxydharz sein, mit dem der Spalt zwischen dem Gehäuse (30) und der Platine (20) gefüllt wird. Zusätzlich kann die Lage des Gehäuses (30) auf der Platine (20) mittels eines Formschlusses sichergestellt werden.

An der Grundfläche (32) des Gehäuses (30) und an der Oberseite (21) der Platine (20) können Markierungen angebracht sein, um bei der Qualitätsprüfung die Genauigkeit der Lage des Gehäuses (30) zur Platine (20) zu ermitteln. Dies erfolgt beispielsweise mittels einer Röntgenmessung. Diese Markierungen bestehen z.B. aus den gleichen Werkstoffen, die auch für die elektrische und/oder thermische Verbindung zwischen dem Gehäuse (30) und der Platine (20) eingesetzt werden. Die Markierungen können Quadrate, Rechtecke, Halbkreise, Kreise, Kreuze, etc. sein, die sich in einem Röntgensystem leicht erkennen lassen.

Die elektrische Verbindung des lichtemittierenden Halbleiterchips (50) mit den elektrischen Leiterbahnen auf der Platine (20) kann über elektrisch leitfähige Bereiche des Gehäuses (30) oder durch elektrische Verbindungen hergestellt werden, die durch das Gehäuse (30) hindurchgeführt werden.

Das Gehäuse (30) wird nun mit dem Werkstoff des Elektronikschutzkörpers (60) gefüllt. Dies erfolgt z.B. mittels Eingießen, Eintropfen, Einspritzen, überdrucken, etc. Hierbei wird das Gehäuse (30) beispielsweise in einer Stufe so befüllt, dass der Werkstoff des Elektronikschutzkörpers (60) bündig mit der Stirnfläche (48) des Gehäuses (30) ist.

Nach der Befüllung wird der Elektronikschutzkörper (60) beispielsweise bei einer Temperatur von 120 Grad Celsius ausgehärtet. Das Aushärten kann auch mit Hilfe von UV-Licht erfolgen.

Bei der Herstellung der lichtemittierenden Halbleiterdiode (10) ohne Gehäuse kann der Elektronikschutzkörper (60) auch z.B. in einer Gussform, in die der lichtemittierende Chip (50) eingesetzt wird, erzeugt werden. Diese lichtemittierende Halbleiterdiode (10) kann dann beispielsweise durch Anlöten an einer Platine befestigt werden.

Die Schichtverbundfolie (70) wird beispielsweise durch Aufbringen der Konverterschicht (72) auf die Trägerschicht (71) erzeugt. Zur Herstellung der Konverterschicht (72) wird zunächst das Konverterpulver (74) mit dem Grundwerkstoff (73) blasenfrei und homogen gemischt. Diese Matrix wird anschließend mit konstanter Schichtdicke auf die Trägerschicht (71) aufgebracht. Bei der Herstellung der Schicht (72) können auch weitere Werkstoffe dem Grundwerkstoff (73) beigemischt werden.

Auch eine Ausführung der Schicht (72) ohne Konverterpulver (74) oder anderen beigemischten Werkstoffen ist denkbar.

Das Aufbringen der so erzeugten Konverterschicht (72) auf die Trägerschicht (71) kann z.B. durch Aufschleudern, Walzen, Vorhanggießen, Aufstreichen etc. erfolgen. Durch diese Verfahren lassen sich eine gute Haftung der Schichten (71, 72) aufeinander und besonders gleichmäßige Schichtdicken erzielen. Ein Ablösen der Schichten (71, 72) voneinander wird hierdurch verhindert. Die beiden Schichten (71, 72) liegen spaltfrei vollflächig aneinander an.

Gegebenenfalls kann die Trägerschicht (71) vor dem Aufbringen der Konverterschicht (72) mittels Plasmabehandlung, chemischer Behandlung, Aufrauhen etc. vorbehandelt werden, um die Haftung der beiden Schichten (71, 72) aufeinander zu verbessern.

Die Schichtverbundfolie (70) wird nun auf den Elektronikschutzkörper (60) aufgebracht. Die Konverterschicht (72) liegt hierbei am Elektronikschutzkörper (60) an. Beispielsweise unter Wärmezufuhr verschmelzen die beiden gleichartigen Werkstoffe. Zusätzlich kann die Schichtverbundfolie (70) auf der Stirnfläche (48) des Gehäuses (30) aufliegen und mit diesem, gegebenenfalls unter Beifügung eines Zusatzwerkstoffs, verbunden werden.

Die Schichtverbundfolie (70) kann auch mehrere, gemeinsam hergestellte Elektronikschutzkörper (60) und Gehäuse (30) überspannen. Beim Vereinzeln der so hergestellten lichtemittierenden Halbleiterdioden (10) wird dann die Schichtverbundfolie (70) durchtrennt.

Die so vorbereitete lichtemittierende Halbleiterdiode (10) wird nun beispielsweise in ein Spritzgießwerkzeug eingesetzt und der Lichtverteilkörper (80) angespritzt. Letzterer verbindet sich unter Einwirkung der Temperatur und des Drucks des Spritzgießverfahrens mit der Trägerschicht (71) der Schichtverbundfolie (70). Gegebenenfalls kann die Trägerschicht (71) hierfür mittels einer Plasmabehandlung vorbereitet werden.

Die Herstellung der lichtemittierenden Halbleiterdiode (10) kann auch in anderer Reihenfolge erfolgen.

Beim Betrieb der lichtemittierenden Halbleiterdiode (10) wird vom lichtemittierenden Halbleiterchip (50) beispielsweise blaues Licht (91 - 93) emittiert. Die beim Betrieb erzeugte Wärme wird über das Gehäuse (30) auf die Platine (20) abgeleitet. Aufgrund der großen Wärmeübergangsflächen zwischen dem lichtemittierenden Chip (50) und dem Gehäuse (30) sowie zwischen dem Gehäuse (30) und der Platine (20) kann der Chip (50) mit einer hohen Leistung betrieben werden.

Das Licht (91 - 93) wird vom Chip (30) in einem Halbraum um die Hauptlichtausbreitungsrichtung (5) in den Elektronikschutzkörper (60) emittiert. Licht (91), das auf die Innenwandungen (39) des Gehäuses (30) trifft, wird an den reflektierenden Schichten (41) in Richtung der Gehäuseöffnung (33) reflektiert.

Beim Übergang aus dem Elektronikschutzkörper (60) in die Schichtverbundfolie (70) wird das Licht (91 - 93) nicht abgelenkt oder reflektiert, da der Werkstoff des Elektronikschutzkörpers (60) und der Grundwerkstoff (73) der Konverterschicht (72) gleich sind und beide Teile (71, 72) spaltfrei miteinander verbunden sind. In der Konverterschicht (72) trifft das Licht (91 - 93) auf die Phosphorpartikel (74). Die Wellenlänge des emittierten Lichts (91 - 93) wird teilweise oder vollständig konvertiert. Für das Auge wird weißes licht sichtbar. Aufgrund der gleichmäßigen Schichtdicke der Konverterschicht (72) entsteht eine weitgehend konstante Farbtemperatur über den Abstrahlbereich der lichtemittierenden Halbleiterdiode (10). Bei einer gleichzeitigen Fertigung mehrerer Leuchtdioden (10) unter Einsatz einer gemeinsamen Schichtverbundfolie (70) haben diese hierdurch auch eine weitgehend gleiche Farbtemperatur.

Innerhalb der Schichtverbundfolie (70) trifft das konvertierte Licht (91 - 93) auf die Grenzfläche (75) zwischen der Konverterschicht (72) und der Trägerschicht (71). An dieser Grenzfläche (75) tritt das Licht (91 - 93), ohne einen Luftspalt zu durchdringen, vom Werkstoff des Elektronikschutzkörpers (60) in den Werkstoff der Trägerschicht (71). Eine Totalreflexion, die zu einer Selbstabsorption des emittierten Lichts (91 - 93) im Elektronikschutzkörper (60) führen könnte, findet nicht statt.

Bei Durchtritt der Grenzfläche (75) tritt das Licht (91 - 93) aus dem Bereich eines Werkstoffs mit einem niedrigen Brechungsindex in den Bereich eines Werkstoffs, dessen Brechungsindex höher als der des erstgenannten Werkstoffes ist. Das Licht wird hierbei in Richtung der Normalen zur Grenzfläche (75) im Durchtrittspunkt gebrochen. Licht (92), das beispielsweise in einem Elektronikschutzkörper (50) mit einem Brechungsindex von 1,41 in einem Winkel von 30 Grad zur Normalen auf die Grenzfläche (75) auftrifft, wird beim Übergang in die Trägerschicht (71) mit einem Brechungsindex von 1,5 in einen Winkel von 28 Grad zur Normalen gebrochen. Hierdurch wird das Licht (91 - 93) gebündelt. Aufgrund des geringen Öffnungswinkels des Lichtbündels ist die leuchtende Fläche klein und die Lichtstärke weitgehend gleichmäßig.

Das fokussierte Licht gelangt nun - ohne weitere Brechung - in den spaltfrei mit der Trägerschicht (71) verbundenen Lichtverteilkörper (80).

Durch den Lichtverteilkörper (80) und die optische Linse (81) hindurch tritt das Licht in die Umgebung (1) aus. Aufgrund des engen Lichtbündels kann die optische Linse (81) geringe äußere Abmessungen aufweisen. Optisch nachgeschaltete Elemente, z.B. weitere optische Linsen, können entsprechend klein dimensioniert werden.

Die enge Lichtführung im Elektronikschutzkörper (60) zusammen mit der steigenden Abfolge der Brechungsindices der Werkstoffe sorgt dafür, dass die lichtemittierende Halbleiterdiode (10) einen engen Öffnungswinkel bei hoher Leuchtdichte aufweist.

Die steigende Abfolge der Brechungsindices ermöglicht es außerdem, einen Öffnungswinkel deutlich kleiner als +/- 90 Grad zu erreichen, ohne dass der Lichtverteilkörper (80) und die optische Linse (81) einen Hinterschnitt aufweisen. Dies erleichtert die Herstellung der lichtemittierenden Halbleiterdiode (10) im Spritzgießverfahren.

### Bezugszeichenliste:

- 1: Umgebung

- 5: Hauptlichtabstrahlrichtung

- 10: lichtemittierende Halbleiterdiode

- 20: Platine, Metallkernplatine
- 21: Oberseite von (20)

- 27: Lotdepots
- 28: wärmeleitendes Polymer

- 30: Gehäuse, Submount
- 31: Boden von (30)
- 32: Grundfläche
- 33: Öffnung

- 36: Seitenwände
- 37: unterer Abschnitt von (36)
- 38: oberer Abschnitt von (36)
- 39: Innenwandungen

- 41: reflektierende Schicht

- 46: Innenboden
- 47: Innenraum
- 48: Stirnfläche

- 50: lichtemittierender Chip
- 51: Oberfläche
- 52: thermisch und elektrisch leitende Verbindung
- 53: Bonddraht

- 60: Elektronikschutzkörper
- 61: Stirnfläche von (60)

- 70: Schichtverbundfolie
- 71: Trägerschicht
- 72: Schicht, Konverterschicht
- 73: Grundwerkstoff
- 74: Konvertermaterial, Konverterpulver
- 75: Grenzfläche

- 80: Lichtverteilkörper
- 81: optische Linse

- 91 - 93: Licht

## Patentansprüche

1. Lichtemittierende Halbleiterdiode, die mindestens einen lichtemittierenden Chip und einen diesen zumindest bereichsweise umgebenden transparenten Elektronikschutzkörper umfasst, **dadurch gekennzeichnet,**
- **dass** zumindest direkt auf dem Elektronikschutzkörper (60) mindestens bereichsweise eine Schichtverbundfolie (70) aufgebracht ist,
- **dass** die Schichtverbundfolie (70) eine dem Elektronikschutzkörper (60) abgewandte Trägerschicht (71) aufweist, deren Brechungsindex größer ist als der Brechungsindex des Elektronikschutzkörper (60), und
- **dass** die Schichtverbundfolie (70) eine dem Elektronikschutzkörper (60) zugewandte Schicht (72) umfasst, deren Grundwerkstoff (73) der Werkstoff des Elektronikschutzkörpers (60) ist.

2. Lichtemittierende Halbleiterdiode nach Anspruch 1, **dadurch gekennzeichnet, dass** der Werkstoff des Elektronikschutzkörpers (60) einen Brechungsindex aufweist, der niedriger ist als 1, 45.

3. Lichtemittierende Halbleiterdiode nach Anspruch 1, **dadurch gekennzeichnet, dass** die dem Elektronikschutzkörper (60) zugewandte Schicht (72) Konvertermaterial (74) enthält.

4. Lichtemittierende Halbleiterdiode nach Anspruch 3, **dadurch gekennzeichnet, dass** das Konvertermaterial (74) ein Phosphor oder ein Gemisch aus Phosphoren ist, die im ultravioletten und/oder im sichtbaren Spektralbereich absorbieren und Licht aussenden, das langwelliger ist als die primäre Strahlung des lichtemittierenden Chips.

5. Lichtemittierende Halbleiterdiode nach Anspruch 1, **dadurch gekennzeichnet, dass** der Trägerschicht (71) ein Lichtverteilkörper (80) optisch nachgeschaltet ist.

6. Lichtemittierende Halbleiterdiode nach Anspruch 5, **dadurch gekennzeichnet, dass** der Lichtverteilkörper (80) aus dem gleichen Werkstoff besteht wie die Trägerschicht (71).

7. Lichtemittierende Halbleiterdiode nach Anspruch 1, **dadurch gekennzeichnet, dass** der lichtemittierende Chip (50) mit einer Metallkernplatine (20) elektrisch und thermisch leitend verbunden ist.

8. Lichtemittierende Halbleiterdiode nach Anspruch 1, **dadurch gekennzeichnet, dass** der lichtemittierende Chip (50) zumindest bereichsweise von einem Gehäuse (30) umgeben ist.

9. Lichtemittierende Halbleiterdiode nach Anspruch 8, **dadurch gekennzeichnet, dass** das Gehäuse (30) als Grundwerkstoff einen nichtmetallischen wärmeleitenden Werkstoff hat.

10. Lichtemittierende Halbleiterdiode nach Anspruch 8, **dadurch gekennzeichnet, dass** der lichtemittierende Chip (50) ohne Bonddrähte mit dem Gehäuse (30) verbunden ist.

11. Lichtemittierende Halbleiterdiode nach Anspruch 8, **dadurch gekennzeichnet, dass** die Schichtverbundfolie (70) auf der in die Hauptlichtabstrahlrichtung (5) orientierte Stirnfläche (48) des Gehäuses (30) aufliegt.

12. Verfahren zur Herstellung einer lichtemittierenden Halbleiterdiode,
- wobei ein lichtemittierender Chip (50) mit einem unter Hitzeeinwirkung aushärtenden transparenten Kunststoff, zur Erzeugung eines Elektronikschutzkörpers (60) umgossen wird,
- wobei eine Schicht (72) konstanter Stärke von maximal 200 Mikrometern, deren Grundwerkstoff (73) gleich dem Werkstoff des Elektronikschutzkörpers (60) ist, zur Herstellung einer Schichtverbundfolie (70) auf eine Trägerschicht (71), die einen höheren Brechungsindex als der Elektronikschutzkörper (60) hat, aufgebracht wird und
- wobei die so hergestellte Schichtverbundfolie (70) auf den Elektronikschutzkörper (60) aufgebracht wird, indem die Schicht (72) mit dem Elektronikschutzkörper (60) unter Hitzeinwirkung oder UV-Strahlungseinwirkung verbunden wird.

13. Verfahren nach Anspruch 12, **dadurch gekennzeichnet, dass** der Werkstoff des Elektronikschutzkörpers (60) einen Brechungsindex unter 1,45 hat.

14. Verfahren nach Anspruch 12, **dadurch gekennzeichnet, dass** die Schicht (72) auf die Trägerschicht (71) aufgewalzt wird.

15. Verfahren nach Anspruch 12, **dadurch gekennzeichnet, dass** Konvertermaterial (74) mit dem Grundwerkstoff (73) der Schicht (72) blasenfrei gemischt wird und diese Matrix anschließend mit homogener Schichtdicke auf die Trägerschicht (71) aufgebracht wird.

16. Verfahren nach Anspruch 12, **dadurch gekennzeichnet, dass** der lichtemittierende Chip (50) auf den Innenboden (46) eines topfartigen Gehäuses (30) befestigt wird und mit diesem zumindest thermisch leitend verbunden wird.

17. Verfahren nach Anspruch 16, **dadurch gekennzeichnet, dass** das Gehäuse (30) an einer Metallkernplatine (20) befestigt wird und mit diesem zumindest thermisch leitend verbunden wird.

18. Verfahren nach Anspruch 17, **dadurch gekennzeichnet, dass** das Gehäuse (30) an der Metallkernplatine (20) mittels flächenhafter Lotdepots (27) mit großer Entwärmungsfläche befestigt wird.

## Claims

1. Light-emitting semiconductor diode which comprises at least one light-emitting chip and a transparent electronics shield at least partly surrounding the latter, **characterised in that**
- a multilayered film (70) is applied at least directly to at least part of the electronics shield (60),
- the multilayered film (70) has a support layer (71), facing away from the electronics shield (60), whose refractive index is greater than the refractive index of the electronics shield (60), and
- the multilayered film (70) comprises a layer (72), facing the electronics shield (60), whose base material (73) is the material of the electronics shield (60).

2. Light-emitting semiconductor diode according to Claim 1, **characterised in that** the material of the electronics shield (60) has a refractive index which is lower than 1.45.

3. Light-emitting semiconductor diode according to Claim 1, **characterised in that** the layer (72) facing the electronics shield (60) comprises converter material (74).

4. Light-emitting semiconductor diode according to Claim 3, **characterised in that** the converter material (74) is a phosphor or a mixture of phosphors which absorb in the ultraviolet and/or visible spectral region and emit light which is of longer wavelength than the primary radiation of the light-emitting chip.

5. Light-emitting semiconductor diode according to Claim 1, **characterised in that** the support layer (71) is followed in the optical path by a light distribution body (80).

6. Light-emitting semiconductor diode according to Claim 5, **characterised in that** the light distribution body (80) consists of the same material as the support layer (71).

7. Light-emitting semiconductor diode according to Claim 1, **characterised in that** the light-emitting chip (50) is connected to a metal core busbar (20) in an electrically and thermally conductive manner.

8. Light-emitting semiconductor diode according to Claim 1, **characterised in that** the light-emitting chip (50) is at least partly surrounded by a housing (30).

9. Light-emitting semiconductor diode according to Claim 8, **characterised in that** the housing (30) has, as base material, a non-metallic thermally conductive material.

10. Light-emitting semiconductor diode according to Claim 8, **characterised in that** the light-emitting chip (50) is connected to the housing (30) without bond wires.

11. Light-emitting semiconductor diode according to Claim 8, **characterised in that** the multilayered film (70) lies on the front face (48) of the housing (30) which is oriented in the principal light emission direction (5).

12. Process for the production of a light-emitting semiconductor diode,
- where a light-emitting chip (50) is surrounded by a cast transparent plastic which cures under the action of heat, in order to produce an electronics shield (60),
- where a layer (72) of constant thickness of at most 200 microns, whose base material (73) is the same as the material of the electronics shield (60), is applied to a support layer (71) which has a higher refractive index than the electronics shield (60), in order to produce a multilayered film (70), and
- where the multilayered film (70) produced in this way is applied to the electronics shield (60) by connecting the layer (72) to the electronics shield (60) under the action of heat or under the action of UV radiation.

13. Process according to Claim 12, **characterised in that** the material of the electronics shield (60) has a refractive index below 1.45.

14. Process according to Claim 12, **characterised in that** the layer (72) is applied to the support layer (71) by roller.

15. Process according to Claim 12, **characterised in that** converter material (74) is mixed with the base material (73) of the layer (72) without bubbles and this matrix is subsequently applied to the support layer (71) in a homogeneous layer thickness.

16. Process according to Claim 12, **characterised in that** the light-emitting chip (50) is fixed to the inside base (46) of a pot-like housing (30) and connected thereto in an at least thermally conductive manner.

17. Process according to Claim 16, **characterised in that** the housing (30) is fixed to a metal core printed circuit board (20) and connected thereto in an at least thermally conductive manner.

18. Process according to Claim 17, **characterised in that** the housing (30) is fixed to the metal core printed circuit board (20) by means of wide-area solder depots (27) having a large heat-dissipation area.

## Revendications

1. Diode semiconductrice émettrice de lumière, laquelle comprend au moins une puce émettrice de lumière et un blindage d'électronique transparent entourant au moins partiellement cette dernière, **caractérisée en ce que** :
- un film multicouche (70) est appliqué au moins directement sur au moins une partie du blindage d'électronique (60),
- le film multicouche (70) comporte une couche de support (71), à distance du blindage d'électronique (60) et lui faisant face, dont l'indice de réfraction est supérieur à l'indice de réfraction du blindage d'électronique (60), et
- le film multicouche (70) comprend une couche (72), qui fait face au blindage d'électronique (60), dont le matériau de base (73) est le matériau du blindage d'électronique (60).

2. Diode semiconductrice émettrice de lumière selon la revendication 1, **caractérisée en ce que** le matériau du blindage d'électronique (60) présente un indice de réfraction inférieur à 1,45.

3. Diode semiconductrice émettrice de lumière selon la revendication 1, **caractérisée en ce que** la couche (72) qui fait face au blindage d'électronique (60) comprend un matériau de convertisseur (74).

4. Diode semiconductrice émettrice de lumière selon la revendication 3, **caractérisée en ce que** le matériau de convertisseur (74) est un phosphore ou un mélange de phosphores qui absorbent dans la région spectrale des ultraviolets et/ou du visible et émettent de la lumière qui est d'une longueur d'onde plus grande que celle du rayonnement primaire de la puce émettrice de lumière.

5. Diode semiconductrice émettrice de lumière selon la revendication 1, **caractérisée en ce que** la couche de support (71) est suivie dans le chemin optique par un corps de distribution de lumière (80).

6. Diode semiconductrice émettrice de lumière selon la revendication 5, **caractérisée en ce que** le corps de distribution de lumière (80) est constitué par le même matériau que celui de la couche de support (71).

7. Diode semiconductrice émettrice de lumière selon la revendication 1, **caractérisée en ce que** la puce émettrice de lumière (50) est connectée à une bus-barre d'âme métallique (20) d'une manière électriquement et thermiquement conductrice.

8. Diode semiconductrice émettrice de lumière selon la revendication 1, **caractérisée en ce que** la puce émettrice de lumière (50) est au moins partiellement entourée par un boîtier (30).

9. Diode semiconductrice émettrice de lumière selon la revendication 8, **caractérisée en ce que** le boîtier (30) comporte, en tant que matériau de base, un matériau thermiquement conducteur non métallique.

10. Diode semiconductrice émettrice de lumière selon la revendication 8, **caractérisée en ce que** la puce émettrice de lumière (50) est connectée au boîtier (30) sans fils de liaison.

11. Diode semiconductrice émettrice de lumière selon la revendication 8, **caractérisée en ce que** le film multicouche (70) s'étend sur la face avant (48) du boîtier (30), laquelle est orientée dans la direction d'émission de lumière principale (5).

12. Procédé pour la fabrication d'une diode semiconductrice émettrice de lumière, dans lequel
une puce émettrice de lumière (50) est entourée par une matière plastique transparente de coulée qui durcit sous l'action de la chaleur, afin de produire un blindage d'électronique (60), dans lequel :
une couche (72) d'une épaisseur constante d'au plus 200 micromètres, dont le matériau de base (73) est le même que le matériau du blindage d'électronique (60), est appliquée sur une couche de support (71) qui présente un indice de réfraction supérieur à celui du blindage d'électronique (60), afin de produire un film multicouche (70), et dans lequel :
le film multicouche (70) produit de cette façon est appliqué sur le blindage d'électronique (60) en connectant la couche (72) au blindage d'électronique (60) sous l'action de la chaleur ou sous l'action d'un rayonnement UV.

13. Procédé selon la revendication 12, **caractérisé en ce que** le matériau du blindage d'électronique (60) présente un indice de réfraction inférieur à 1,45.

14. Procédé selon la revendication 12, **caractérisé en ce que** la couche (72) est appliquée sur la couche de support (71) au moyen d'un rouleau.

15. Procédé selon la revendication 12, **caractérisé en ce qu'**un matériau de convertisseur (74) est mélangé avec le matériau de base (73) de la couche (72) sans bulles et cette matrice est ensuite appliquée sur la couche de support (71) selon une épaisseur de couche homogène.

16. Procédé selon la revendication 12, **caractérisé en ce que** la puce émettrice de lumière (50) est fixée sur la base interne (46) d'un boîtier en forme de pot (30) et lui est connectée d'une manière au moins thermiquement conductrice.

17. Procédé selon la revendication 16, **caractérisé en ce que** le boîtier (30) est fixé sur une carte de circuit imprimé à âme en métal (20) et lui est connecté d'une manière au moins thermiquement conductrice.

18. Procédé selon la revendication 17, **caractérisé en ce que** le boîtier (30) est fixé sur la carte de circuit imprimé à âme en métal (20) au moyen de dépôts de soudure large zone (27) présentant une zone de dissipation thermique importante.
